# EUROPEAN PATENT SPECIFICATION

(11) **EP 2 481 578 B1**
(45) Date of publication and mention of the grant of the patent: **13.08.2014**
(21) Application number: 12165686.2
(22) Date of filing: 03.12.2009
(51) Int. Cl.: B32B 27/00

(54) **Method for edge sealing barrier films**
Verfahren zur Randversiegelung von Sperrfilmen
Procédé de scellement étanche de bords de films barrières

(30) Priority: 30.12.2008 US 345787
(43) Date of publication of application: 01.08.2012
(62) Divisional of application: 09774785.1
(73) Proprietor: Samsung Display Co., Ltd., Yongin-City, Gyeonggi-Do (KR)
(72) Inventor: Chu, Xi, Fremont, CA 94538 (US); Burrows, Paul E., 137-875 Seoul (KR); Mast, Eric S., Richland, WA 99352 (US); Martin, Peter M., Kennewick, WA 99338 (US); Graff, Gordon L., West Richland, WA 99353 (US); Gross, Mark E., Pasco, WA 99301 (US); Bonham, Charles C., Richland, WA 99352 (US); Bennett, Wendy D., Kennewick, WA 99337 (US); Rosenblum, Martin Philip, Menlo Park, CA 94025 (US)
(74) Representative: Mounteney, Simon James

(56) References cited:
- EP-A- 0 611 037
- EP-A- 1 719 808
- EP-A- 1 857 270
- WO-A-99/33651
- WO-A-02/051626
- WO-A-2006/093898
- DE-A1-102004 063 619

## Description

The invention relates generally to multilayer, thin film barrier composites, and more particularly, to multilayer, thin film barrier composites having the edges sealed against lateral moisture and gas diffusion.

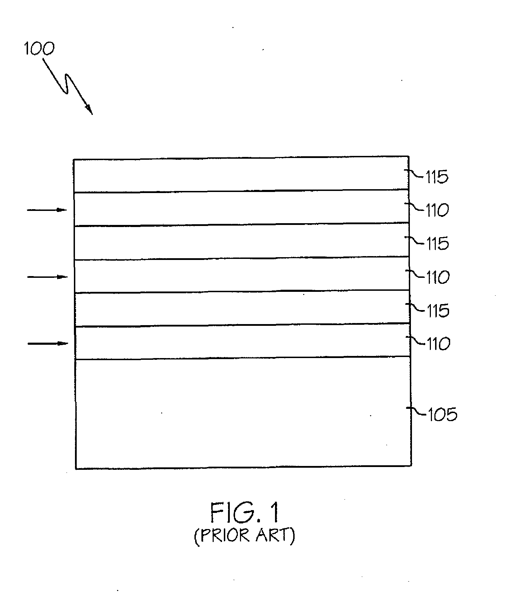

Multilayer, thin film barrier composites having alternating layers of barrier material and polymer material are known. These composites are typically formed by depositing alternating layers of barrier material and polymer material, such as by vapor deposition. If the polymer layers are deposited over the entire surface of the substrate, then the edges of the polymer layers are exposed to oxygen, moisture, and other contaminants. This potentially allows the moisture, oxygen, or other contaminants to diffuse laterally into an encapsulated environmentally sensitive device from the edge of the composite, as shown in Fig. 1. The multilayer, thin film barrier composite 100 includes a substrate 105 and alternating layers of decoupling material 110 and barrier material 115. The scale of Fig. 1 is greatly expanded in the vertical direction. The area of the substrate 105 will typically vary from a few square centimeters to several square meters, The barrier layers 115 are typically a few hundred Angstroms thick, while the decoupling layers 110 are generally less than ten microns thick. The lateral diffusion rate of moisture and oxygen is finite, and this will eventually compromise the encapsulation, One way to reduce the problem of edge diffusion is to provide long edge diffusion paths. However, this decreases the area of the substrate which is usable for active environmentally sensitive devices. In addition, it only lessens the problem, but does not eliminate it.

A similar edge diffusion problem will arise when a substrate containing a multilayer, thin film barrier composite is scribed and separated to create individual components,

Thus, there is a need for an edge-sealed barrier film composite, and for a method of making such a composite.

In another embodiment, the method includes providing an environmentally sensitive device on a substrate; depositing a decoupling layer using a thermal gradient, the decoupling layer adjacent to the environmentally sensitive device, the decoupling layer having a discrete area and covering the environmentally sensitive device; and depositing a. first barrier layer adjacent to the decoupling layer, the first barrier layer having an area greater than the discrete area of the decoupling layer and covering the decoupling layer, the decoupling layer being sealed between the edges or the first barrier layer and the substrate or an optional second barrier layer, wherein the environmentally sensitive device is selected from the group consisting of organic light emitting devices, liquid crystal displays, displays using electrophoretic inks, light emitting diodes, light emitting polymers, electroluminescent devices, phosphorescent devices, organic photovoltaic devices, inorganic photovoltaic devices, thin film batteries, and thin film devices with vias, microelectromechanical systems (*MEMS*), Electro-Optic Polymer Modulators, and combinations thereof.

By adjacent, we mean next to, but not necessarily directly next to, There can be additional layers intervening between the substrate and the barrier stacks, and between the barrier stacks and the environmentally sensitive device, etc.
Fig. 1 is a cross-section of a barrier composite of the prior art.
Fig. 2 is a cross-section of one emhodiment of an edge-sealed, encapsulated environmentally sensitive device of the present invention.
Fig. 3 shows a successful barrier layer without a seal after 750 hours at 60°C and 90% relative humidity.
Fig. 4 shows a successful edge seal after 750 hours at 60°C and 90% relative humidity.
Fig. 5 shows a failed edge seal after 750 hours at 60°C and 90% relative humidity.

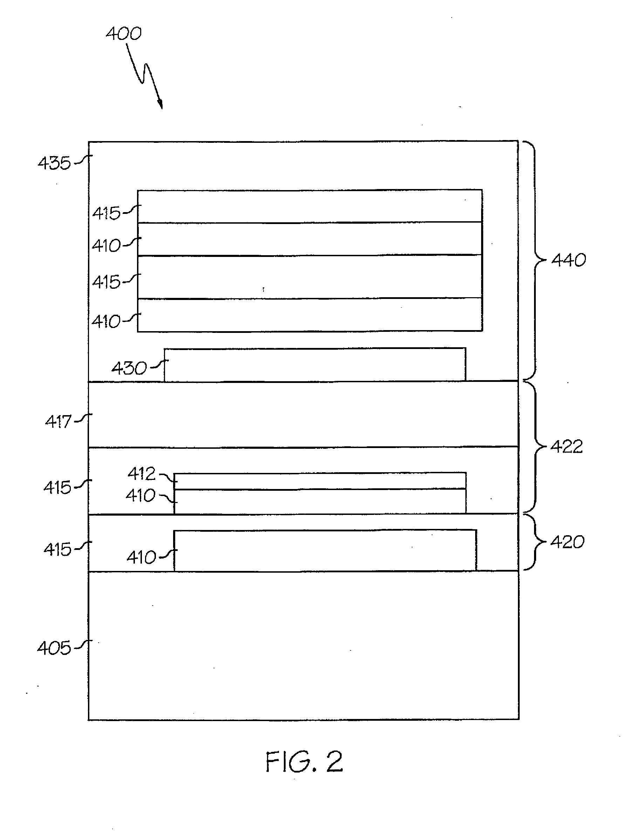

Fig. 2 shows an edge-sealed, encapsulated environmentally sensitive device 400. There is a substrate 405 which can be removed after the device is made, if desired. The environmentally sensitive device 430 is encapsulated between initial barrier stack 422 on one side and additional barrier stack 440 on the other side. There is another initial barrier stack 420 between the substrate 405 and initial barrier stack 422.

The substrate can be any suitable substrate, and can be either rigid or flexible. Suitable substrates include, but are not limited to: polymers, for example, polyethylene terephthalate (PET), polyethylene naphthalate (PEN), or high temperature polymers, such as polyether sulfone (PES), polyimides, or Trarisphan™ (a high glass transition temperature cyclic olefin polymer available from Lofo High Tech Film, GMBH of Weil am Rhein, Germany) (including polymers with barrier stacks thereon); metals and metal foils; paper; fabric; glass, including thin, flexible, glass sheet (for example, flexible glass sheet available from Coming Inc. under the glass code 0211. This particular thin, flexible glass sheet has a thickness of less than 0.6 mm and will bend at a radium of about 8 inches.); ceramics; semiconductors; silicon; and combinations thereof.

Barrier stack 420 has a barrier layer 415 which has an area greater than the area of the decoupling layer 410 which seals the decoupling layer 410 within the area of the barrier layer 415. Barrier stack 422 has two barrier layers 415, 417 and two decoupling layer 410, 412. Barrier layer 415 has an area greater than that of the decoupling layers 410, 412 which seals the decoupling layers 410, 412 within the area of the barrier layer 415. There is a second barrier layer 417. Because the decoupling layers 410, 412 are sealed within the area covered by the barrier layer 415, ambient moisture, oxygen, and other contaminants cannot diffuse through the decoupling layers to the environmentally sensitive device,

On the other side of the environmentally sensitive device 430, there is an additional barrier stack 440. Barrier stack 440 includes two decoupling layers 410 and two barrier layers 415 which may be of approximately the same seize, Barrier stack 440 also includes barrier layer 435 which has an area greater than the area of the decoupling layers 410 which seals the decoupling layers 410 within the area of barrier layer 435.

It is not required that all of the barrier layers have an area greater than all of the decoupling layers, but at least one of the barrier layers must have an area greater than at least one of the decoupling layers. If not all of the barrier layers have an area greater than of the decoupling layers, the barrier layers which do have an area greater than the decoupling layers should form a seal around those which do not so that there are no exposed decoupling layers within the barrier composite, although, clearly it is a matter of degree. The fewer the edge areas of decoupling layers exposed, the less the edge diffusion. If some diffusion is acceptable, then a complete barrier is not required.

The barrier stacks of the present invention on polymeric substrates, such as PET, have measured oxygen transmission rate (OTR) and water vapor transmission rate (WVTR) values well below the detection limits of current industrial instrumentation used for permeation measurements (Mocon OxTran 2/20L and Permatran). Table 1 shows the OTR and WVTR values (measured according to ASTM F 1927-98 and ASTM F 1249-90, respectively) measured at Mocon (Minneapolis, MN) for several barrier stacks on 7 mil PET, along with reported values for other materials.

**Table 1**

| **Sample** | **Oxygen Permeation Rate (cc/m²/day)** | | **Water Vapor Permeation (g/m²/day)⁺** | |
|---|---|---|---|---|
| | **23°C** | **38°C** | **23°C** | **38°C** |
| Native 7 mil PET | 7.62 | - | - | - |
| 1-barrier stack | <0.005 | <0.005* | - | 0.46⁺ |
| 1-barrier stack with ITO | <0.005 | <0.005* | - | 0.011⁺ |
| 2-barrier stacks | <0.005 | <0.005* | - | <0.005⁺ |
| 2-barrier stacks with ITO | <0.005 | <0.005* | - | <0.005⁺ |
| 5-barrier stacks | <0.005 | <0.005* | - | <0.005⁺ |
| 5-barrier stacks with ITO | <0.005 | <0.005* | - | <0.005⁺ |
| DuPont film¹ (PET/Si₃N₄ or PEN/Si₃N₄) | 0.3 | - | - | - |
| Polaroid³ | <1.0 | - | - | - |
| PET/Al² | 0.6 | - | 0.17 | - |
| PET/silicon oxide² | 0.7-1.5 | - | 0.15-0.9 | - |
| Teijin LCD film (HA grade - TN/STN)³ | <2 | - | <5 | - |

| | | | | |
|---|---|---|---|---|
| (*) 38°C, 90% RH, 100% O₂ (+) 38°C, 100% RH 1 - P. F. Carcia, 46th International Symposium of the American Vacuum Society, Oct. 1999 2 - Langowski, H.C., 39th Annual Technical Conference Proceedings, SVC, pp. 398-401 (1996) 3 - Technical Data Sheet | | | | |

As the data in Table 1 shows, the barrier stacks of the present invention provide oxygen and water vapor permeation rates several orders of magnitude better than PET coated with aluminum, silicon oxide, or aluminum oxide. Typical oxygen permeation rates for other barrier coatings range from about 1 to about 0.1 cc/m²/day. The oxygen transmission rate for the barrier stacks of the present invention is less than 0.005 cc/m²/day at 23°C and 0% relative humidity, and at 38°C and 90% relative humidity. The water vapor transmission rate is less than 0.005 g/m²/day at 38°C and 100% relative humidity. The actual transmission rates are lower, but cannot be measured with existing equipment.

In theory, a good edge seal should be no more permeable than the overall barrier layer. This should result in failure at the edges occurring at a rate statistically the same as that observed anywhere else, In practice, the areas closest to the edge show failure first, and the inference is that edge failure is involved.

The Mocon test for the barrier layers requires significant surface area, and cannot be used to test the edge seal directly. A test using a layer of calcium was developed to measure barrier properties. The calcium test is described in Nisato et al., "Thin Film Encapsulation for OLEDs: Evaluation of Multi-layer Barriers using the Ca Test," SID 03 Digest, 2003, p. 550-553, which is incorporated herein by reference. The calcium test can be used to evaluate edge seal performance for both oxygen transmission rate and water vapor transmission rate, An encapsulated device is made, and the edges are observed for degradation in response to permeation by oxygen and water. The determination is qualitative: pass/fail. Failure is noted at the edges, and the failure progresses inwards from the edges over time. An edge seal which passes the calcium test has an oxygen transmission rate for the edge seal of less than 0.005 cc/m²/day at 23°C and 0%n relative humidity, and at 38°C and 30% relative humidity. It would also have a water vapor transmission rate of less than 0.005 g/m²/day at 38°C and 100% relative humidity.

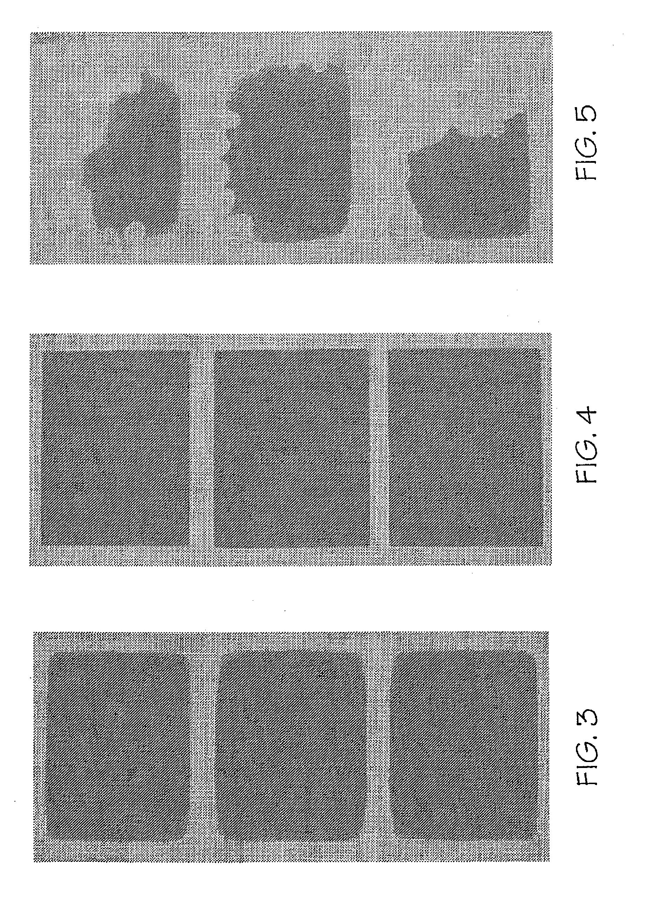

Figs. 3-5 show results from calcium tests after 750 hours at 60°C and 90% relative humidity. Fig, 3 shows a successful barrier layer without a seal. The edge of the barrier layer is more than 50 mm from the calcium edge. Fig. 4 shows a successful edge seal. The edge of the barrier layer is 3 mm from the calcium edge, and no degradation is observed. Fig. 5 shows an edge seal which failed. The edge of the barrier layer is 3 mm from the calcium edge, and severe degradation can be seen.

The number of barrier stacks is not limited. The number of barrier stacks needed depends on the substrate material used and the level of permeation resistance needed for the particular application. One or two barrier stacks may provide sufficient barrier properties for some applications. The most stringent applications may require five or more barrier stacks.

The barrier stacks can have one or more decoupling layers and one or more barrier layers. There could be one decoupling layer and one barrier layer, there could be one or more decoupling layers on one side of one or more barrier layers, there could be one or more decoupling layers on both sides of one or more barrier layers, or there could be one or more barrier layers on both sides of one or more decoupling layers. The important feature is that the barrier stack have at least one decoupling layer and at least one barrier layer. The barrier layers in the barrier stacks can be made of the same material or of a different material, as can the decoupling layers.

The barrier layers are typically about 100 to about 2000 Å thick. The initial barrier layer can be thicker than later barrier layers, if desired. For example, the first barrier layer might be in the range of about 1000 to about 1500 Å, while later barrier layers might be about 400 to about 500 Å. In other situations, the first barrier layer might be thinner than later barrier layers. For example, the first barrier layer might be in the range of about 100 to about 400 Å, while later barrier layers might be about 400 to about 500 Å. The decoupling layers are typically about 0.1 to about 10 µm thick. The first decoupling layer can be thicker than later decoupling layers, if desired. For example, the first decoupling layer might be in the range of about 3 to about 5 µm, while later decoupling layers might be about 0.1 to about 2 µm.

The barrier stacks can have the same or different layers, and the layers can be in the same or different sequences.

If there is only one barrier stack and it has only one decoupling layer and one barrier layer, then the decoupling layer must be first in order for the barrier layer to seal it. The decoupling layer will be sealed between the substrate (or the upper layer of the previous barrier stack) and the barrier layer. Although a device can be made with a single barrier stack having one decoupling layer and one barrier layer on each side of the environmentally sensitive device, there will typically be at least two barrier stacks on each side, each stack having one (or more) decoupling layer and one (or more) barrier layer. In this case, the first layer in the stack can be either a decoupling layer or a barrier layer, as can the last layer.

The barrier layer which seals the decoupling layer may be the first barrier layer in the barrier stack, as shown in barrier stack 420. It may also be a second (or later) barrier layer as shown in barrier stack 440, Barrier layer 435 which seals the barrier stack 440 is the third barrier layer in the barrier stack following two barrier layers 415 which do not seal the barrier stack. Thus, the use of the terms first decoupling layer and first barrier layer in the claims does not refer to the actual sequence of layers, but to layers which meet the limitations. Similarly, the terms first initial barrier stack and first additional barrier stack do not refer to the actual sequence of the initial and additional barrier stacks.

The decoupling layers may be made from the same decoupling material or different decoupling material. The decoupling layer can be made of any suitable decoupling material, including, but not limited to, organic polymers, inorganic polymers, organometallic polymers, hybrid organic/inorganic polymer systems, and combinations thereof. Organic polymers include, but are not limited to, urethanes, polyamides, polyimides, polybutylenes, isobutylene isoprene, polyolefins, epoxies, parylenes, benzocyclobutadiene, polynorbornenes, polyarylethers, polycarbonates, alkyds, polyaniline, ethylene vinyl acetate, ethylene acrylic acid, and combinations thereof. Inorganic polymers include, but are not limited to, silicones, polyphosphazenes, polysilazanes, polycarbosilanes, polycarboranes, carborane siloxanes, polysilanes, phosphonitriles, sulfur nitride polymers, siloxanes, and combinations thereof. Organometallic polymers include, but are not limited to, organometallic polymers of main group metals, transition metals, and lanthanide/actinide metals, or combinations thereof. Hybrid organic/inorganic polymer systems include, but are not limited to, organically modified silicates, preceramic polymers, polyimide-silica hybrids, (meth)acrylate-silica hybrids, polydimethylsiloxane-silica hybrids, and combinations thereof.

The barrier layers may be made from the same barrier material or different barrier material. The barrier layers can be made of any suitable barrier material. Suitable inorganic materials based on metals include, but are not limited to, individual metals, two or more metals as mixtures, inter-metallics or alloys, metal and mixed metal oxides, metal and mixed metal fluorides, metal and mixed metal nitrides, metal and mixed metal carbides, metal and mixed metal carbouitrides, metal and mixed metal oxynitrides, metal and mixed metal borides, metal and mixed metal oxyborides, metal and mixed metal silicides, or combinations thereof. Metals include, but are not limited to, transition ("d" block) metals, lanthanide ("f" block) metals, aluminum, indium, germanium, tin, antimony and bismuth, and combinations thereof. Many of the resultant metal based materials will be conductors or semiconductors. The fluorides and oxides will include dielectrics (insulators), semiconductors and metallic conductors. Non-limiting examples of conductive oxides include aluminum doped zinc oxide, indium tin oxide (ITO), antimony tin oxide, titanium oxides (TiOₓ where 0.8 ≤ x ≤ 1) and tungsten oxides (WOₓ where 2.7 ≤ x < 3.0). Suitable inorganic materials based on p block semiconductors and non-metals include, but are not limited to, silicon, silicon compounds, boron, boron compounds, carbon compounds including amorphous carbon and diamond-like carbon, and combinations of. Silicon compounds include, but are not limited to silicon oxides (SiOₓ where 1 ≤ x ≤ 2), polysilicic acids, alkali and alkaline earth silicates, aluminosilicates (AlₓSiO_{y}), silicon nitrides (SNₓH_{y} where 0 ≤ y < 1), silicon oxynitrides (SiNₓO_{y}H_{z} where 0 ≤ z < 1), silicon carbides (SiCₓH_{y} where 0 ≤ y < 1), and silicon aluminum oxynitrides (STALONs). Boron compounds include, but are not limited to, boron carbides, boron nitrides, boron oxynitrides, boron carbonitrides, and combinations thereof with silicon.

The barrier layers may be deposited by any suitable process including, but not limited to, conventional vacuum processes such as sputtering, evaporation, sublimation, chemical vapor deposition (CVD), plasma enhanced chemical vapor deposition (PECVD), electron cyclotron resonance-plasma enhanced vapor deposition (ECR-PECVD), and combinations thereof.

The deposition of the decoupling layer can be controlled using a thermal gradient on the substrate (with or without the environmentally sensitive device). The area in which the decoupling layer is to be deposited is cooled, while the surrounding area is not cooled, creating a temperature gradient in the area surrounding the cooled area. The monomer condenses.more rapidly on the cooled portion, and less rapidly (or not at all) on the surrounding area which is not cooled. The area which is not cooled could be heated if desired. The monomer can then be processed into a polymer as discussed above. The resulting polymeric decoupling layer will be thicker in the cooled area and thinner in the surrounding area, tapering off from the cooled portion to the surrounding portion. This allows the formation of a patterned polymeric decoupling layer. The barrier layer can then be deposited over the area covered by decoupling layer as well as the surrounding area at least a portion of which is not covered by the decoupling area. The barrier layer surrounding the decoupling layer will be in contact with a previously deposited barrier layer or the substrate, sealing the decoupling layer between the barrier layer and either the previous barrier layer or the substrate. While this process may not be able to provide an edge seal with the precision needed for some devices, it may be satisfactory for other devices,

Alternatively, the area on which monomer should not be deposited can be heated while the remaining area on which the monomer is to be deposited is not heated. The area on which the monomer is to be deposited can be cooled if desired.

Any subsequent decoupling layer can be produced by a number of known processes which provide improved surface planarity, including both atmospheric processes and vacuum processes. Any subsequent decoupling layer may be formed by depositing a layer of liquid and subsequently processing the layer of liquid into a solid film, Depositing the decoupling layer as a liquid allows the liquid to flow over the defects in the substrate or previous layer, filling in low areas, and covering up high points, providing a surface with significantly improved planarity. When the decoupling layer is processed into a solid film, the improved surface planarity is retained. Suitable processes for depositing a layer of liquid material and processing it into a solid film include, but are not limited to, vacuum processes and atmospheric processes. Suitable vacuum processes include, but are not limited to, those described in U.S. Patent Nos. 5,260,095, 5,395,644, 5,547,508, 5,691,615, 5,902,641, 5,440,446, and 5,725,909. The liquid spreading apparatus described in 5,260,095, 5,395,644, and 5,547,508 can be further configured to print liquid monomer in discrete, precisely placed regions of the receiving substrate.

Suitable atmospheric processes include, but are not limited to, spin coating, printing, ink jet printing, and/or spraying. By atmospheric processes, we mean processes run at pressures of about 1 atmosphere that can employ the ambient atmosphere. The use of atmospheric processes presents a number of difficulties including the need to cycle between a vacuum environment for depositing the barrier layer and ambient conditions for the decoupling layer, and the exposure of the environmentally sensitive device to environmental contaminants, such as oxygen and moisture. One way to alleviate these problems is to use a specific gas (purge gas) during the atmospheric process to control exposure of the receiving substrate to the environmental contaminants. For example, the process could include cycling between a vacuum environment for barrier layer deposition and an ambient pressure nitrogen environment for the atmospheric process, Printing processes, including inkjet printing, allow the deposition of the decoupling layer in a a precise area without the use of masks.

One way to make a decoupling layer involves depositing a polymer precursor, such as a (meth)acrylate containing polymer precursor, and then polymerizing it *in situ* to form the decoupling layer. As used herein, the term polymer precursor means a material which can be polymerized to form a polymer, including, but not limited to, monomers, oligomers, and resins. As another example of a method of making a decoupling layer, a preceramic precursor could be deposited as a liquid by spin coating and then converted to a solid layer. Full thermal conversion is possible for a film of this type directly on a glass or oxide coated substrate. Although it cannot be fully converted to a ceramic at temperatures compatible with some flexible substrates, partial conversion to a cross-lined network structure would be satisfactory, Electron beam techniques could be used to crosslink and/or densify some of these types of polymers and can be combined with thermal techniques to overcome some of the substrate thermal limitation, provided the substrate can handle the electron beam exposure. Another example of making a decoupling layer involves depositing a material, such as a polymer precursor, as a liquid at a temperature above its melting point and subsequently freezing it in place.

When one of the barrier stacks includes two or more decoupling layers, the substrate can be passed by one or more decoupling material deposition stations one or more times before being moved to the barrier deposition stations. The decoupling layers can be made from the same decoupling material or different decoupling material. The decoupling layers can be deposited using the same process or using different processes.

Similarly, one or more barrier stacks can include two or more barrier layers. The barrier layers can be formed by passing the substrate (either before or after the decoupling layers have been deposited) past one or more barrier deposition stations one or more times, building up the number of layers desired. The layers can be made of the same or different barrier material, and they can be deposited using the same or different processes.

One or more functional layers can be included, if desired. Various types of functional layers could be used if desired, including, but not limited to hardcoat layers, photoresist layers, antiglare layers, antireflection layers, impact protective coatings, and antismear/fingerprint coatings, and the like. The functional layer can be deposited in discrete areas, e.g., using a printing process as discussed above. Alternatively, the functional layer can be deposited using processes that cover an overall area, either with or without the use of a mask. If the functional layer is deposited in a discrete area, it would not need to be removed to expose the contacts. For example, the functional layer could be a hardcoat layer which is an etch resistant material It would then act as an etch mask. Suitable etch resistant hardcoat materials include, but are not limited to, silanes or siloxanes, hexafluorobenzene, pentafluorostyrene, perfluoro-1,3-butadiene or chlorocarbon compounds, and thermoplastic polymer (e.g., mr-I8000 from micro resist technology GmbH). The three layers of barrier material are then removed to expose the contacts 830, The environmentally sensitive devices can then be separated with each device being protected by the edge sealed barrier layers.

While certain representative embodiments and details have been shown for purposes of illustrating the invention, it will be apparent to those skilled in the art that various changes in the compositions and methods disclosed herein may be made without departing from the scope of the invention, which is defined in the appended claims.

## Claims

1. A method of making an edge-sealed, encapsulated environmentally sensitive device comprising:
providing an environmentally sensitive device on a substrate;
depositing a polymeric decoupling layer using a thermal gradient, the polymeric decoupling layer adjacent to the environmentally sensitive device, the polymeric decoupling layer having a discrete area and covering the environmentally sensitive device; and
depositing a first barrier layer adjacent to the polymeric decoupling layer, the first barrier layer having an area greater than the discrete area of the polymeric decoupling layer and covering the polymeric decoupling layer, the polymeric decoupling layer being sealed between the edges of the first barrier layer and the substrate or an optional second barrier layer, wherein the environmentally sensitive device is selected from the group consisting of: organic light emitting devices, liquid crystal displays, displays using electrophoretic inks, light emitting diodes, light emitting polymers, electroluminescent devices, phosphorescent devices, organic photovoltaic devices, inorganic photovoltaic devices, thin film batteries, thin film devices with vias, micromechanical systems (*MEMS*), Electro-Optic Polymer Modulators, and combinations thereof.

2. The method of claim 1 wherein depositing the polymeric decoupling layer using a thermal gradient comprises:
cooling a first portion of the substrate and not cooling a second portion of the substrate; depositing a monomer on the first portion of the substrate and not on at least a part of the second portion of the substrate; and
processing the monomer into the polymeric decoupling layer.

3. The method of claim 1 wherein depositing the polymeric decoupling layer using a thermal gradient comprises:
heating a first portion of the substrate and not heating a second portion of the substrate;
depositing a monomer on the second portion of the substrate and not on at least a part of the first portion of the substrate; and
processing the monomer into the polymeric decoupling layer.

4. The product made by the method of claim 1.

## Patentansprüche

1. Verfahren zur Herstellung einer randversiegelten, eingekapselten, gegen Umgebungseinflüsse empfindlichen Vorrichtung, umfassend:
Bereitstellen einer gegen Umgebungseinflüsse empfindlichen Vorrichtung auf einem Substrat;
Aufbringen einer polymeren Entkopplungsschicht mittels eines thermischen Gradienten, wobei die polymere Entkopplungsschicht benachbart zu der gegen Umgebungseinflüsse empfindlichen Vorrichtung ist, wobei die Entkopplungsschicht einen diskreten Bereich aufweist und die gegen Umgebungseinflüsse empfindliche Vorrichtung abdeckt; und
Aufbringen einer ersten Sperrschicht benachbart zur polymeren Entkopplungsschicht, wobei die erste Sperrschicht einen Bereich aufweist, der größer als der diskrete Bereich der polymeren Entkopplungsschicht ist und die polymere Entkopplungsschicht abdeckt, die polymere Entkopplungsschicht zwischen den Rändern der ersten Sperrschicht und dem Substrat oder einer optionalen zweiten Sperrschicht versiegelt wird, wobei die gegen Umgebungseinflüsse empfindliche Vorrichtung aus der Gruppe ausgewählt ist, die aus Folgendem besteht:
organischen Licht emittierenden Vorrichtungen, Flüssigkristallanzeigen, Anzeigen, welche elektrophoretische Tinten verwenden, Leuchtdioden, Licht emittierenden Polymeren, Elektrolumineszenzvorrichtungen, phosphoreszierenden Vorrichtungen, organischen photovoltaischen Vorrichtungen, anorganischen photovoltaischen Vorrichtungen, Dünnfilmbatterien, Dünnfilmvorrichtungen mit Kontaktlöchern, mikroelektromechanischen Systemen (MEMS), elektrooptischen Polymermodulatoren und Kombinationen davon.

2. Verfahren nach Anspruch 1, wobei das Aufbringen der polymeren Entkopplungsschicht mittels eines thermischen Gradienten das Folgende umfasst:
Abkühlen eines ersten Teils des Substrats und nicht abkühlen eines zweiten Teils des Substrats;
Aufbringen eines Monomers auf den ersten Teil des Substrats und nicht auf mindestens einen Abschnitt des zweiten Teils des Substrats; und
Verarbeiten des Monomers zu der polymeren Entkopplungsschicht.

3. Verfahren nach Anspruch 1, wobei das Aufbringen der polymeren Entkopplungsschicht mittels eines thermischen Gradienten das Folgende umfasst:
Wärmen eines ersten Teils des Substrats und nicht wärmen eines zweiten Teils des Substrats;
Aufbringen eines Monomers auf den zweiten Teil des Substrats und nicht auf mindestens einen Abschnitt des ersten Teils des Substrats; und
Verarbeiten des Monomers zu der polymeren Entkopplungsschicht.

4. Produkt, hergestellt durch das Verfahren nach Anspruch 1.

## Revendications

1. Procédé de réalisation d'un dispositif sensible à l'environnement encapsulé, à bords scellés, comprenant les étapes consistant à :
fournir un dispositif sensible à l'environnement sur un substrat ;
déposer une couche de découplage polymérique au moyen d'un gradient thermique, la couche de découplage polymérique étant à côté du dispositif sensible à l'environnement, la couche de découplage polymérique présentant une zone distincte et couvrant le dispositif sensible à l'environnement ; et
déposer une première couche barrière à côté de la couche de découplage polymérique, la première couche barrière présentant une zone qui est plus grande que la zone distincte de la couche de découplage polymérique et qui couvre la couche de découplage polymérique, la couche de découplage polymérique étant scellée entre les bords de la première couche barrière et le substrat ou une deuxième couche barrière facultative, dans lequel le dispositif sensible à l'environnement est sélectionné parmi le groupe constitué de :
dispositifs organiques émetteurs de lumière, affichages à cristaux liquides, affichages utilisant des encres électrophorétiques, diodes électroluminescentes, polymères émetteurs de lumière, dispositifs électroluminescents, dispositifs phosphorescents, dispositifs photovoltaïques organiques, dispositifs photovoltaïques minéraux, batteries à couches minces, dispositifs à couches minces à vias, systèmes microélectromécaniques (MEMS), modulateurs à polymères électro-optiques et des combinaisons de ceux-ci.

2. Procédé selon la revendication 1, dans lequel déposer la couche de découplage polymérique au moyen d'un gradient thermique comprend :
refroidir une première partie du substrat et ne pas refroidir une seconde partie du substrat ; déposer un monomère sur la première partie du substrat et non sur au moins une partie de la seconde partie du substrat ; et
transformer le monomère en la couche de découplage polymérique.

3. Procédé selon la revendication 1, dans lequel déposer la couche de découplage polymérique au moyen d'un gradient thermique comprend :
chauffer une première partie du substrat et ne pas chauffer une seconde partie du substrat ;
déposer un monomère sur la seconde partie du substrat et non sur au moins une partie de la première partie du substrat ; et
transformer le monomère en la couche de découplage polymérique.

4. Produit réalisé au moyen du procédé selon la revendication 1.
